# EUROPEAN PATENT SPECIFICATION

(11) **EP 0 644 430 B1**
(45) Date of publication and mention of the grant of the patent: **24.10.2001**
(21) Application number: 94110967.0
(22) Date of filing: 14.07.1994
(51) Int. Cl.: G01R 21/127

(54) **Static kWh meter**
Statischer Kilowattstundenzähler
Compteur kWh statique

(30) Priority: 16.09.1993 FI 934060
(43) Date of publication of application: 22.03.1995
(73) Proprietor: ENERMET OY, SF-40420 Jyskä (FI)
(72) Inventor: Lahti, Teuvo, 40100 Jyväskylä (FI)
(74) Representative: Tiedtke, Harro, Dipl.-Ing.

(56) References cited:
- WO-A-85/00893
- DE-A- 2 926 979
- US-A- 3 794 917
- IEEE TRANSACTIONS ON INSTRUMENTATION AND MEASUREMENT, vol.39, no.1, February 1990, NEW YORK,US pages 15 - 18, XP000101403 FILIPSKI 'a tdm wattmeter'

## Description

The present invention concerns a static kWh meter according to the preamble of independent claim-1 which corresponds to the disclosure of WO 85/00893.

With respect to the prior art, reference is made to the FI Patents Nos. 67,960 and 67,961 in which static kWh meters are described that are based on a pulse-width/ pulse-height multiplier, i.e. on a time-division multiplier. The main components of such a kWh meter, i.e. a three-phase meter, comprise members connected to the wires of the electricity network for the generation of measurement signals Uᵤ, Iᵢ proportional to the voltage U and to the current I, a multiplier circuit for the formation of a pulse-width/pulse-height modulated signal that represents the product of the measurement signals, and integration members supplied by the output of the pulse-width/pulse-height multiplier in a converter circuit, from which a frequency signal proportional to the power is obtained, which signal is passed through a divider circuit to the counter of the meter for determination of the energy consumed.

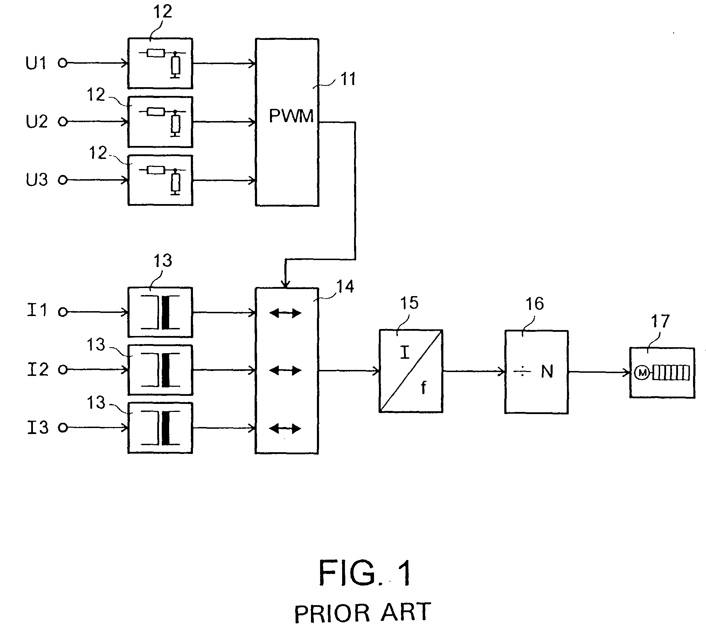

Such a prior-art static kwh meter is illustrated in Fig. 1 in the drawings. In the meter, a sequence of sample pulses is formed, in which the pulse width is proportional to the momentary value of the voltage, and the pulse height is proportional to the momentary value of the current, the area of the pulses being proportional to the product of voltage and current, i.e. to the power. As a rule, the sample pulse frequency is about 10...20 times higher than the mains frequency. The modulating signal in the pulse-width modulator is a signal proportional to the mains voltage, which signal is formed by means of a voltage divider. From the pulse-width modulator, a pulse sequence is obtained, in which the width of each pulse is proportional to the momentary value of the mains voltage.

In view of accuracy of measurement, it is preferable to use current measurement converters in the current form, because, in such a case, no precision resistors are needed in parallel with the secondary circuits of the current measurement converters, nor are second precision resistors needed, by whose means the voltage pulses received from the sampling swithches are converted to current pulses, which are fed to the integrator of the voltage-frequency converter. The principle of operation of a voltage-frequency converter is similar to that of a current-frequency converter, with the difference that in a voltage-frequency converter the voltage to be converted is first converted to current, and this current is fed to the integration amplifier of the converter.

When a current measurement converter is used in the current form, the secondary circuit of the current measurement converter must not be allowed to remain open during the time between the sample pulses, because the secondary voltage of the current measurement converter would, in such a case, become very high and destroy the components in the circuit. This is why, in the secondary circuit of a current measurement converter, it is necessary to use two analog switches so that, when the sampling switch is proper in the non-conductive state, the other analog switch, which short-circuits the secondary circuit of the current measurement converter is in the conductive state. Such a procedure is described, e.g., in *US Patent No. 3,794,917*, and so also in Fig. 2 in the drawings in relation to the description of the prior art.

In the embodiment described in *US Patent No. 4,315,212,* the current measurement converter is used in the voltage form, which requires the use of several precision resistors in the current measurement circuit. Also in such solutions, which use the current measurement converter in the voltage form, there are at least two analog connectors in the secondary circuit of each current measurement converter.

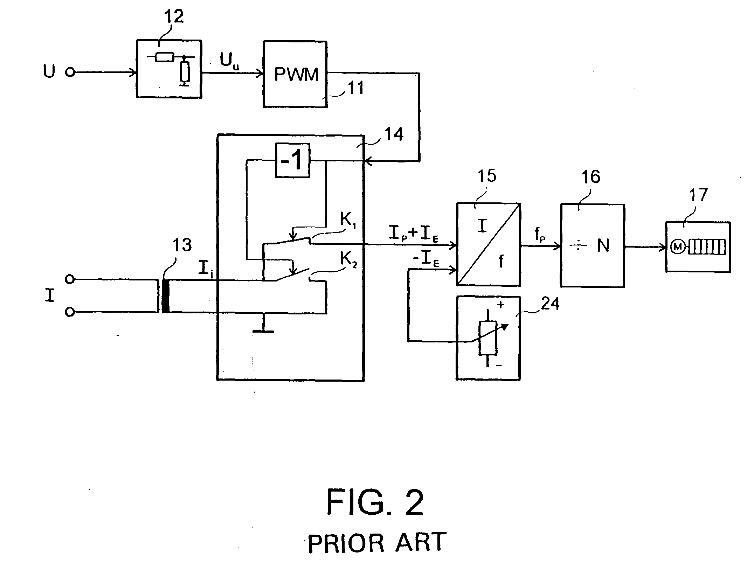

Analog switches have a detrimental property, for they produce extra voltage and current pulses in the signal to be measured. Extra pulses are produced when the analog switches are closed and opened. The pulse that is produced when an analog switch is opened is, as a rule, of opposite sign, compared with the pulse that is produced when an analog switch is closed, but these pulses are not of equal magnitude and, thus, they do not compensate for each other's effects. By the effect of the switching pulses, an extra DC component I_{E} is produced in the measurement circuit, which DC component deteriorates the accuracy of measurement especially when the current Iₚ proportional to the power to be measured is low. In the prior-art solution as illustrated in Fig. 2, the detrimental DC component I_{E} produced by the analog switches is compensated for by means of an external regulation member.

Furthermore, document IEEE Transactions on Instrumentation and Measurement, vol. 39, no. 1, Frebruary 1990, pages 15 to 18, P. Filipski, "A TDM Wattmeter with 0.5-MHz Carrier Frequency" discloses a standard time-division multiplier (TDM) wattmeter with a constant average carrier frequency of a synchronized multivibrator and zero systematic phase error of an astable mulivibrator PWM. Specifically, in a secondary circuit of the current measurement converter of the wattmeter there is provided a multiplier circuit which is connected with analog switches which are controlled by the pulse sequence received from a pulse-width modulator, and currents received from the analog switches and being proportional to the power and of opposite signs are fed to two converters.

The object of the present invention is to provide an improvement over the prior-art static kWh meters. It is a more specific object of the invention to provide a static kWh meter in which the extra DC component I_{E} that is produced in the measurement circuit by the effect of switching pulses can be eliminated reliably without necessity to make use of any external regulation member.

This object is accomplished according to the present invention by a static kWh meter as set out in the appended claim 1. In the invention, it has been realized to solve the detrimental effect of the direct current I_{E} produced by the analog switches in a simple way so that this detrimental effect is compensated for without necessity to use an external regulation member. The solution in accordance with the invention compensates for the effect of the DC component I_{E} under all circumstances irrespective of any change in the value of I_{E}, for example, as a function of temperature or time.

According to the invention, the analog switches, which are already present in the secondary circuit of a current measurement converter, are utilized so that the direct currents +Iₚ and -Iₚ of opposite signs, which are received from the analog switches and which correspond to the power to be measured, are passed to separate current-frequency converters, the frequencies received from said converters being summed together. Since the current-frequency converters operate with control signals of opposite signs, the extra direct current I_{E} produced by the measurement signal of the analog switches results in an increase in the frequency of one current-frequency converter and in a lowering of the frequency of the other current-frequency by a corresponding amount. Thus, the summed frequency of the current-frequency converters is independent from the extra DC component summed in the measurement current.

By means of the device in accordance with the present invention, the additional advantage is achieved that, when the frequencies of current-frequency converters are compared with one another, it is possible to accomplish monitoring of the operation of the kwh meter, and the user of the meter can be warned of any component defect or other failure that may have occurred in the circuit. If the frequencies of the current-frequency converters differ from each other to a considerable extent, it can be assumed that there is a serious defect in the measurement electronics, and in such a case the measurement of energy can be stopped. By means of this procedure, a defect in the kwh meter is noticed in time and erroneous invoicing of the consumer of electric energy can be prevented.

By means of an arrangement in accordance with the invention, the additional advantage is obtained that, in a kwh meter, it is possible to use actively compensated current measurement converters, in whose output signal, as a rule, a little DC component has been summed, because the solution of the present invention permits summing of a direct current I_{E} that may be even equal to the current I_{P} comparable with the power in the measurement current circuit.

The invention will be described in detail with reference to a preferred embodiment of the invention illustrated in the figures in the accompanying drawings, the invention being, yet, not supposed to be confined to said embodiment alone.

Figure 1 shows a prior-art static kwh meter as a block diagram.

Figure 2 shows a prior-art static kwh meter as a block diagram, wherein the switching arrangement of the multiplier circuit is shown in more detail in respect of one phase.

Figure 3 shows a static kwh meter in accordance with the invention as a block diagram, wherein the switching arrangement of the muliplier circuit is shown in more detail in respect of one phase.

Figure 4 shows the circuit diagram of a current-frequency converter as well as the wave forms occurring at different points in the wiring system.

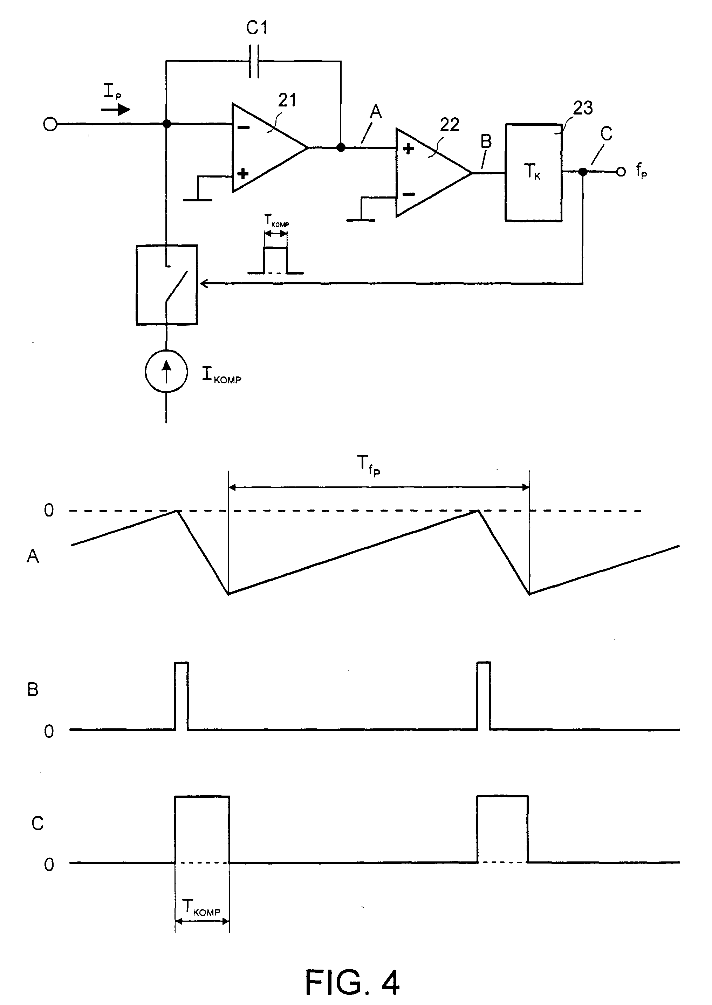

In the following the term "static kWh meter" is understood as a kWh meter containing no moving parts in the measuring arrangement. The prior-art static kwh meter shown in Figs. 1 and 2 comprises voltage dividers 12 and current measurement converters 13, which are connected to the wires of the electricity network so as to generate measurement signals Uᵤ, Iᵢ proportional to the voltage U and to the current I, and a multiplier circuit 11,14 to form a pulse-width/ pulse-height modulated signal which respresents the product of the measurement signals. By means of the square waves received from the pulse-width modulator 11, the analog switches K₁ and K₂ placed in the secondary circuit of the current measurement converters 13 are controlled, and from the outputs of said switches K₁ and K₂ pulses are received, whose height is proportional to the current passing in the measurement current circuit and whose width is still modulated by the mains voltage. The pulses are filtered, whereby a direct current Iₚ proportional to the power is obtained, which direct current is fed to the current-frequency converter 15, whose diagram of principle is illustrated in Fig. 4.

According to Fig. 4, the current-frequency converter 15 consists of an integration amplifier 21, which integrates the output of the multiplier 11,14, as well as of an indicator 22 of the threshold level, which indicator starts a timer circuit 23, which feeds a current pulse I_{KOMP} of a sign opposite to the sign of the measurement signal to the input of the integrator 21. These current pulses, which compensate for the charge of the integration capacitor Cl, are fed to the input of the integrator 21 the more frequently, the higher the input current Iₚ arriving at the integrator 21 from the multiplier 11,14 is.

Thus, from the output of the current-frequency converter 15, a pulse frequency fₚ is obtained, which is proportional to the direct current Iₚ, i.e. to the power, fed to the integrator 21, which pulse frequency fₚ is passed through the divider circuit 16 to the counter 17 of the meter. The counter 17 integrates the power, i.e. displays the energy consumed.

By the effect of the switching pulses, an extra DC component I_{E} is produced in the measurement circuit, which component deteriorates the accuracy of measurement in particular when the current to be measured is low. In the solution of Fig. 2, the DC component I_{E} is compensated for by an external regulation member 24, from which a current -I_{E} of opposite sign and of equal magnitude is fed to the current-frequency converter 15. This procedure requires a regulation member 24 outside the circuit and an extra regulation operation during the manufacture of the meter. Also, this procedure compensates for the effect of the DC component I_{E} at the moment and at the temperature only at which the tuning operation is carried out.

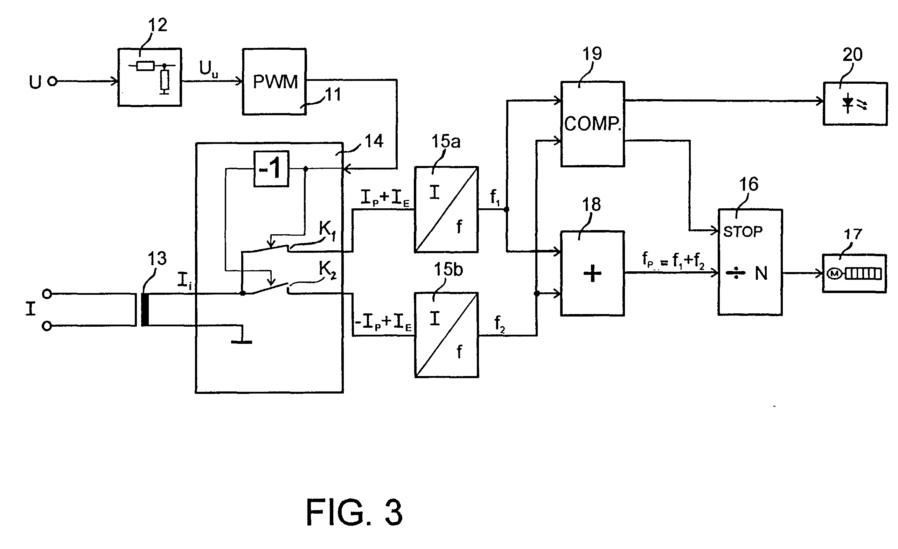

In the solution in accordance with the invention as shown in Fig. 3, the direct currents +Iₚ and -Iₚ of opposite signs, which are received from the analog switches K₁ and K₂ and which are proportional to the power, are fed to two current-frequency converters 15a and 15b. Since the current-frequency converters 15a and 15b operate with control signals of opposite signs, the extra direct current I_{E} produced by the analog switches K₁ and K₂ in the measurement signal results in an increase in the frequency of one current-frequency converter and in a lowering of the frequency of the other current-frequency converter by a corresponding amount. Thus, the summed frequency of the current-frequency converters 15a and 15b is independent from the extra DC component I_{E} summed in the measurement current. The output frequencies f₁ and f₂ of the current-frequency converters 15a, 15b are summed in the summing unit 18, and the sum frequency f₁ + f₂ produced is the ultimate frequency fₚ proportional to the power.

The frequencies f₁ and f₂ are additionally fed to a frequency comparator circuit 19, which gives an alarm by switching on, e.g., a signal lamp 20 if the frequencies f₁ and f₂ differ from one another to a greater extent than a pre-set amount or limit. If the difference in frequency exceeds another pre-set limit, the comparator circuit 19 stops the operation of the divider circuit 16 and prevents access of the pulses to the counter 17. Instead of a signal lamp 20, it is, of course, possible to use any display device or any other mode or device of failure detection.

The kwh meter in accordance with the invention is accomplished advantageously so that the components 11,14,15a,15b,16,18, and 19 for metering of energy and for monitoring are accomplished as one microcircuit made to order.

Above, just a solution of principle of the invention is described, and it is obvious for a person skilled in the art that numerous modifications can be made to said solution within the scope of the inventive idea disclosed in the accompanying claims.

## Claims

1. Static kWh meter, which comprises members (12, 13) connected to wires of an electricity network for respectively generating measurement signals (Uᵤ, Iᵢ) proportional to a voltage (U) and a current (I), while the secondary circuit of one of said members (12, 13) being a current measurement converter (13, 14) comprises analog switches (K₁, K₂) and a multiplier circuit (14) for the formation of a pulse-width and pulse-height modulated signal that represents the product of the measurement signals (Uᵤ, Iᵢ), and integration members (21, Cl) included in a converter circuit (15) and supplied by the output of said pulse-width and pulse-height multiplier circuit (14) to said converter circuit (15) from which a frequency signal (fₚ) is obtained, the frequency of which is proportional to the power and which is passed through a divider circuit (16) to a counter (17) of the static kWh meter for determination of the energy that has been consumed, **characterized in that**
the secondary circuit of the current measurement converter (13, 14) of each phase of said network is said multiplier circuit (14), including the analog switches (K₁, K₂) which operate as a change-over switch and are controlled by a pulse sequence received from a pulse-width modulator (11), and that the direct currents (+Iₚ, -Iₚ) received from the analog switches (K₁, K₂) of the multiplier circuit (14), which are proportional to the power and of opposite signs, are fed to said converter circuit (15) built up by current-frequency converters (15a, 15b) the output frequencies (f₁, f₂) of which are summed in a summing unit (18), and the sum frequency (f₁ + f₂) that is formed is the frequency signal (fₚ) the frequency of which is proportional to the power.

2. Static kWh meter as claimed in claim 1, **characterized in that**
the output frequencies (f₁, f₂) of the current-frequency converters (15a, 15b) are additionally passed to a comparator circuit (19) so as to compare said output frequencies (f₁, f₂) with each other all the time.

3. Static kWh meter as claimed in claim 2, **characterized in that**
the comparator circuit (19) is fitted to give an alarm if the output frequencies (f₁, f₂) differ from one another more than a first pre-set limit.

4. Static kWh meter as claimed in claim 2 or 3, **characterized in that**
the comparator circuit (19) is fitted to stop the operation of the divider circuit (16) and to prevent access of the pulses to the counter (17) if the difference between the output frequencies (f₁, f₂) exceeds a second pre-set limit.

5. Static kWh meter as claimed in claim 3 or 4, **characterized in that** the meter is provided with a signal lamp (20) that indicates an alarm or a failure.

6. Static kWh meter as claimed in any of the claims 1 to 5, **characterized in that**
the components (11, 14, 15a, 15b, 16, 18, and 19) including the analog switches (K₁, K₂) for metering of energy and for monitoring have been accomplished as one microcircuit made to order.

## Patentansprüche

1. Statische kWh-Messeinrichtung mit einem Element (12), das mit Leitungen eines elektrischen Netzes verbunden ist, zur jeweiligen Erzeugung von zu einer Spannung (U) und zu einem Strom (I) proportionalen Messsignalen (U_{U}, I_{I}), während eine Sekundärschaltung eines Strommesswandlers (13, 14) analoge Schalter (K₁, K₂), eine Multiplizierschaltung (14) zur Ausbildung eines pulsbreiten- und pulshöhenmodulierten Signals, das das Produkt der Messsignale (U_{U}, I_{I}) darstellt, und Integrationselemente (21, Cl) aufweist, die in einer Wandlerschaltung (15) beinhaltet sind und durch die Ausgabe der Pulsbreiten- und Pulshöhenmultiplizierschaltung (14) zu der Wandlerschaltung (15) versorgt werden, von der ein Frequenzsignal (fₚ) erlangt wird, wobei dessen Frequenz proportional zu der Leistung ist und durch eine Dividierschaltung (16) zu einer Zähleinheit (17) der statischen kWh-Messeinrichtung zur Bestimmung der verbrauchten Energie geführt wird,
**dadurch gekennzeichnet, dass**
die Sekundärschaltung des Strommesswandlers (13, 14) einer jeden Phase des Systems die Multiplizierschaltung (14) aufweist, welche die analogen Schalter (K₁, K₂) beinhaltet, die in entgegengesetzten Schaltrichtungen betrieben werden, wobei die analogen Schalter (K₁, K₂) durch eine von einer Pulsbreitenmodulationseinheit (11) empfangene Impulsfolge gesteuert werden, und dass die von den analogen Schaltern (K₁, K₂) der Multiplizierschaltung (14) empfangenen Gleichströme (+Iₚ, -Iₚ), welche proportional zu der Leistung sind und entgegengesetzte Vorzeichen aufweisen, zu in der Wandlerschaltung (15) beinhalteten Strom-Frequenz-Wandlern (15a, 15b) geführt werden, deren Ausgangsfrequenzen (f₁, f₂) in einer Summiereinheit (18) summiert werden, wobei die ausgebildete Summenfrequenz (f₁+f₂) dem Frequenzsignal (fₚ) entspricht, dessen Frequenz proportional zu der Leistung ist.

2. Statische kWh-Messeinrichtung nach Anspruch 1,
**dadurch gekennzeichnet, dass**
die Ausgangsfrequenzen (f₁, f₂) der Strom-Frequenz-Wandler (15a, 15b) zusätzlich zu einer Vergleichsschaltung (19) geführt werden, um die Ausgangsfrequenzen (f₁, f₂) ständig miteinander zu vergleichen.

3. Statische kWh-Messeinrichtung nach Anspruch 2,
**dadurch gekennzeichnet, dass**
die Vergleichsschaltung (19) eingerichtet ist, einen Alarm auszugeben, falls die Ausgangsfrequenzen (f₁, f₂) voneinander um mehr als eine erste voreingestellte Grenze differieren.

4. Statische kWh-Messeinrichtung nach Anspruch 2 oder 3,
**dadurch gekennzeichnet, dass**
die Vergleichsschaltung (19) eingerichtet ist, den Betrieb der Dividierschaltung (16) zu stoppen und einen Zugang der Impulse zu der Zähleinheit (17) zu verhindern, falls die Differenz zwischen den Ausgangsfrequenzen (f₁, f₂) eine zweite voreingestellte Grenze übersteigt.

5. Statische kWh-Messeinrichtung nach einem der Ansprüche 3 oder 4,
**dadurch gekennzeichnet, dass**
die Messeinrichtung mit einer Signallampe (20) ausgestattet ist, die einen Alarm oder einen Fehler angibt.

6. Statische kWh-Messeinrichtung nach einem der Ansprüche 1 bis 5,
**dadurch gekennzeichnet, dass**
die Komponenten (11, 14, 15a, 15b, 16, 18 und 19) zur Messung von Energie und zur Überwachung als eine auf Anweisung hergestellte Mikroschaltung ausgeführt worden sind.

## Revendications

1. Compteur de kWh statique, qui comprend des éléments (12, 13) raccordés aux fils d'un réseau d'électricité pour générer respectivement des signaux de mesure (Uᵤ, Iᵢ) proportionnels à une tension U et à un courant (I), alors que le circuit secondaire d'un desdits éléments (12, 13) étant un convertisseur de mesure de courant (13, 14) comprend des commutateurs analogiques (K₁, K₂) et un circuit multiplieur (14) pour la formation d'un signal modulé en largeur d'impulsion et en hauteur d'impulsion qui représente le produit des signaux de mesure (Uᵤ, Iᵢ), et des éléments d'intégration (21, C1) compris dans un circuit convertisseur (15) et délivré par la sortie dudit circuit multiplieur de largeur d'impulsion et de hauteur d'impulsion (14) audit circuit convertisseur (15) à partir duquel un signal de fréquence (fₚ) est obtenu, dont la fréquence est proportionnelle à la puissance et qui traverse un circuit diviseur (16) jusqu'à un compteur (17) du compteur de kWh statique pour la détermination de l'énergie qui a été consommée,
**caractérisé en ce que** le circuit secondaire du convertisseur de mesure de courant (13, 14) de chaque phase dudit réseau est un circuit multiplieur (14) comprenant les commutateurs analogiques (K₁, K₂) qui fonctionnent comme un inverseur et sont commandés par une séquence d'impulsions reçue du modulateur de largeur d'impulsion (11) et **en ce que** des courants directs (+Ip, -Ip) reçus des commutateurs analogiques (K₁, K₂) du circuit multiplieur (14) qui sont proportionnels à la puissance et de signes opposés, sont fournis audit circuit convertisseur (15) constitué par des convertisseurs de courant-fréquence (15a, 15b) dont les fréquences de sortie (f₁, f₂) sont ajoutées dans une unité d'addition (18), et la fréquence de somme (f₁ + f₂) qui est formée, est le signal de fréquence dont la fréquence (fₚ) est proportionnelle à la puissance.

2. Compteur de kWh statique selon la revendication 1, **caractérisé à ce que** les fréquences de sortie (f₁, f₂) des convertisseurs de courant-fréquence (15a, 15b) sont passées additionnellement à un circuit comparateur (19) afin de comparer tout le temps lesdites fréquences de sortie (f₁, f₂) les unes avec les autres.

3. Compteur de kWh statique selon la revendication 2, **caractérisé en ce que** le circuit comparateur (19) est adapté pour donner une alarme si les fréquences de sortie (f₁, f₂) diffèrent les unes des autres de plus d'une première limite préréglée.

4. Compteur de kWh statique selon la revendication 2 ou 3 **caractérisé en ce que**
le circuit comparateur (19) est adapté pour arrêter le fonctionnement du circuit diviseur (16) et pour empêcher l'accès des impulsions au compteur (17) si la différence entre les fréquences de sortie (f₁, f₂) dépasse une seconde limite préréglée.

5. Compteur de kWh statique selon la revendication 3 ou 4, **caractérisé en ce que** le compteur est pourvu d'un voyant de signal (20) qui indique une alarme ou une panne.

6. Compteur de kWh statique selon l'une quelconque des revendications 1 à 5, **caractérisé en ce que** les composants (11, 14, 15a, 15b, 16, 18 et 19) comprenant les commutateurs analogiques (K₁, K₂) pour mesurer l'énergie et pour contrôler ont été réalisés comme un micro-circuit destiné à être commandé.
